# EUROPEAN PATENT SPECIFICATION

(11) **EP 2 417 841 B1**
(45) Date of publication and mention of the grant of the patent: **30.01.2013**
(21) Application number: 10711413.4
(22) Date of filing: 30.03.2010
(51) Int. Cl.: H05K 3/20, H05K 3/02, H05K 3/38

(54) **A METHOD OF MANUFACTURING A CIRCUIT CARRIER LAYER AND A USE OF SAID METHOD FOR MANUFACTURING A CIRCUIT CARRIER**
VERFAHREN ZUR HERSTELLUNG EINER SCHALTUNGSTRÄGERSCHICHT UND ANWENDUNG DIESES VERFAHRENS ZUR HERSTELLUNG EINES SCHALTUNGSTRÄGERS
PROCÉDÉ DE FABRICATION D'UNE COUCHE DE SUPPORT DE CIRCUIT ET UTILISATION DE CE PROCÉDÉ POUR LA FABRICATION D'UN SUPPORT DE CIRCUIT

(30) Priority: 09.04.2009 EP 09090006
(43) Date of publication of application: 15.02.2012
(73) Proprietor: Atotech Deutschland GmbH, 10553 Berlin (DE)
(72) Inventor: LUETZOW, Norbert, 12205 Berlin (DE); SPARING, Christian, 13507 Berlin (DE); TEWS, Dirk, 10318 Berlin (DE); THOMS, Martin, 13156 Berlin (DE)
(74) Representative: Bressel, Burkhard
(86) International application number: PCT/EP2010/054196
(87) International publication number: WO 2010/115774

(56) References cited:
- EP-A1- 0 930 811
- WO-A1-2006/067280
- WO-A1-2007/091807
- JP-A- 9 064 514
- US-A1- 2003 219 608
- US-A1- 2005 175 824
- US-A1- 2006 115 671

## Description

### Field of the Invention

The present invention relates to a method of manufacturing a circuit carrier layer and a use of said method for manufacturing a circuit carrier. Such methods are used in producing very fine line geometries of conductor line and pad patterns required in complex electronic products.

### Background Art

With increased miniaturization of the circuitries on printed circuit boards or on other circuit carriers, new production technologies have emerged. Standard subtractive technologies are not capable of producing ultra fine line geometries, because under-etching of the base copper limits line resolution. Instead of subtractive processes, semi-additive processes being employed currently comprise the following method steps: a) depositing either directly onto a dielectric or onto an ultra-thin copper film a thin electroless copper layer, b) dry film application, c) pattern plating, d) dry film stripping, and e) differential etching of the electroless copper layer (and, if applicable, any underlying copper film).

For achieving HDI conductor structures (HDI = High Density Interconnect; conductor structures comprising circuit traces having a line width of at most 100 µm and a spacing between the traces of at most 100 µm) an initial ultra-thin copper layer is applied to the surface of the board. HDI conductor structures used in the industry so far are to a degree of greater than 95% made by discrete circuits located on the surface of the board. The structures in different circuit planes are either electrically connected by mechanically drilled through holes or by laser drilled micro vias.

With decreasing size of the ultra-fine conductor lines the contact area of the lines to the dielectric becomes so small that sufficient adhesion of the lines to the dielectric will no longer be satisfactory.

One alternative approach to overcome this adhesion problem is to embed the circuit lines into the dielectric:
DE 196 20 095 A1 discloses a method of manufacturing printed circuit boards by first forming trenches and through holes, preferably by laser ablation using an excimer laser, in a dielectric which is attached for example to a carrier frame. Then, the dielectric is provided with a ground layer that is next selectively removed again except from the sites of the trenches and through holes. The remaining ground layer is now metal-plated for forming conductor structures such as circuit traces and through-plated holes, either directly or after light activation, in the trenches and holes, such that the conductor lines formed in the trenches are embedded in the dielectric. Another possibility described therein is to dispense with selective treatment of the ground layer and to directly deposit metal on the entire surface thereof. The through holes may thereby also be completely filled with metal. In this case, the metal is next etched back as far as the dielectric with the filled trenches and through holes being formed flush with the dielectric.

EP 0 677 985 A1 discloses another method of manufacturing printed circuit boards. This document turns away from multiple layers of substrates and the like prior art processes requiring multilayer laminated materials, which are assessed to be expensive and often not available in constant quality. At first, various recesses are produced in a carrier substrate by means of laser ablation, preferably using an excimer laser, like also shown in DE 196 20 095 A1. Next, through holes are formed, using further laser ablation. A conductive material is thereafter deposited substantially on the entire surface of the substrate, said conductive material being next reinforced preferably by plating, with the material being also deposited onto the walls of the through holes. In a last step, the deposited conductive material is removed by mechanical polishing except for in the recesses and through holes.

Embedding of the conductor lines offers the advantage that the circuitry is contacted to the dielectric material on the bottom footprint as well as to the two side walls. Therefore, the conductor lines are in direct contact at three sides thereof to the dielectric, thus stabilizing the integrity thereof.

Such method is for example disclosed in US 2006/0016553 A1. This document discloses a method of fabricating a high density printed circuit board. This method comprises applying a strippable adhesive layer on a rigid substrate or carrier film used as a base substrate, forming a metal foil on the adhesive layer by means of plating, lamination or sputtering, and forming a high density circuit on the metal foil serving as a seed layer by means of pattern plating, laminating an insulating layer on the circuit pattern and removing the rigid substrate or carrier film by stripping and the seed layer by flash-etching.

US 2003/0219608 A1 discloses a method of producing a reliable, compact, thin-layer ceramic condenser by first producing a metal transfer sheet having a first metal layer and a second metal layer which are laminated through a passive film interposed there between, second transferring the second metal layer of the metal transfer sheet to a ceramic green sheet including peeling the metal transfer sheet and releasing the second metal layer from the first metal layer via the passive film, third laminating the ceramic green sheet to which the second metal layer was transferred and fourth baking the ceramic green sheet laminated.

Another method is disclosed in US 4,606,787 A. This document discloses a method for providing fine line, high density multiple layer printed circuit board packages. For the production thereof, a rigid metal or metallized plate substrate is provided first. Then, a flash of copper is electroplated onto this substrate. This copper flash serves as a releasing material for separating the printed circuitry from the substrate after formation of the printed circuit board is complete. For generating the circuitry a layer of photosensitive resist material is applied to the copper flash surface, is exposed and developed. Thereafter, the substrate is plated with copper. After plating is complete, the resist is stripped away from the copper flash surface. Then a layer of insulating material is laminated to the copper flash layer completely covering the copper flash and the raised conductive circuit pattern. Finally the insulator material is manually separated from the surface of the substrate and the copper flash layer is removed using conventional etching techniques.

Another method is disclosed in WO 2006/067280 A. This document relates to a method of producing a conductive pattern by forming a separating layer on an auxiliary substrate, where the surface is conductive, forming a patterned resist layer on the separating layer, electrodepositing a conductive pattern on the separating layer in openings formed in the patterns of the resist layer, embedding and attaching the conductive pattern to electrically insulating material and removing the auxiliary substrate from the rest of the layer structure mechanically. The auxiliary substrate may be made of metal, such as stainless steel, or a film-like ribbon or a copper-coated plastic film. The separating layer may be formed from a release layer and optionally of an intermediate layer. The release layer may be made of metals or organic substances such as of carboxybenzotriazole. The intermediate layer may be made of copper. After electrodeposition of the conductive pattern, same may be roughened by known techniques to provide better adhesion to the insulating circuit board material. The resist layer may or may not be removed after electrodeposition is complete. The electrically insulating material may be hardening epoxy, thermoplastic or disposable plastic. Mechanical removal of the auxiliary substrate may be carried out easily if the release layer has been properly produced. Any remains of the release layer attached to the insulating circuit board material can be removed by etching.

Other substances to form a release layer are disclosed in EP 0 930 811 A1. This document refers to a composite copper foil and a process for preparing same. The composite foil comprises an organic release layer between a metal carrier layer and an ultra-thin copper foil. It provides a uniform bond strength which is adequate to prevent separation of the carrier and ultra-thin copper foil during handling and lamination, but which is significant lower than the peel strength of a copper/substrate bond, so that the carrier can easily be removed after lamination of the composite foil. The ultra-thin copper foil is generated on the organic release layer by electrodeposition. The organic release layer is for example a nitrogen-containing compound or a sulfur-containing compound. The class of nitrogen-containing compounds comprises for example carboxybenzotriazole, N,N'-bis(benzotriazolylmethyl)urea or 3-amino-1H-1,2,4-triazole. The class of sulfur-containing compounds comprises for example mercaptobenzothiazole, thiocyanuric acid and 2-benzimidazolethiol.

If a steel plate is used to produce the copper pattern thereon elaborate preparation of these panels will be required. In addition, even plating of the first (seed) copper layer will have to be tightly monitored. As a flash copper used as a release layer must be removed by etching, several additional disadvantages result including additional process steps, the danger of damaging the circuitry formed, copper containing waste water accruing and uniform copper crystal formation being required because of uniform etching being required. The latter necessitates annealing of the device being formed.

Further, the difficulty of these process sequences is the need to improve dry film adhesion to the flash copper film without removing the flash copper film. Therefore, it may be very difficult to have the flash copper be flash-etched while ensuring that the embedded circuitry is not damaged. Classically, dry film adhesion is improved by mechanically or chemically roughening the copper surface. Employing an etching solution for roughening flash copper adds the danger of etching through the flash copper in single spots. In addition the roughened surface topography is being transferred to the plated circuitry causing a loss in signal integrity for high frequency applications. For this reason, a relatively thick copper foil has to be formed on the auxiliary substrate in order to prevent the above problems. This again however, requires larger amounts of chemicals and brings about larger amount of copper waste water.

### Short Description of the Invention

Therefore, an object of the present invention is to provide a method of producing high density circuits on a dielectric substrate wherein the conductor lines of said circuit have a good adhesion to the dielectric substrate surface.

Another object of the present invention is to provide a method of producing high density circuits on a dielectric substrate wherein the circuit does not experience relevant loss in signal integrity in high frequency applications.

Yet another object of the present invention is to provide a method of producing high density circuits on a dielectric substrate wherein the conductor pattern is produced using a patterned resist coating and wherein the adhesion of said resist coating is sufficiently high and not impaired in any treatment steps used to complete formation of the high density circuit on the dielectric substrate.

These objects and further objects are achieved with a method of manufacturing a circuit carrier layer and by a use of said method for manufacturing a circuit carrier, a printed circuit board for example, by joining together at least two circuit carrier layers, preferably by stacking same one over another and firmly attaching same together, for example by laminating.

The method of the invention is defined in the appended claims.

Using the method of the invention provides circuit carrier layers which are suitable in producing circuit carriers which are provided with ultra-fine line conductor structures. Embedding the conductor structures in the dielectric material of the base substrate of the circuit carriers ensures reliably producing finest conductor structures. Furthermore, mechanically removing the auxiliary substrate from the dielectric base material and embedded electrically conductive pattern makes easy and cost-effective production of such circuit carrier layers possible. The method of the invention involving producing the electrically conductive pattern first on an auxiliary substrate and then embedding same into a dielectric material further results in avoiding the disadvantages being due to the conventional processes such as CMP (chemically mechanically polishing) if the embedded circuit pattern is directly formed in recesses formed in the dielectric material.

By using the method of the invention dry film adhesion to the employed copper is improved, but the topography of the electrically conductive surface of the auxiliary substrate is not changed, *i.e.*, the electrically conductive surface is not rendered rough, but is instead kept substantially smooth. As a result a flat electrically conductive surface is achieved and therefore loss in high frequency signal integrity is low compared to state-of-the-art methods. Even under these conditions good adherence of the polymeric deposit to the electrically conductive surface may be achieved, though hitherto it has been assumed that good adherence may only be observed if the base surface has been made rough or is rough as prepared. This result is astonishing since a strong bond between the surface and the polymeric deposit has been believed to be only due to an enlargement of the specific surface area of said surface.

Good adherence has been proved by visually inspecting consistency of a finest line pattern in a photo-imageable photoresist laminated on a copper surface and exposed and developed and additionally by testing adherence with a tape test at such processed photo-imageable photoresist layer. Consistency and adherence have been proved excellent. This is in spite of the fact, that the electrically conductive surface is not substantially affected by the pretreatment method of the invention, *i.e.*, no noticeable roughening takes place when said surface is treated with the release layer forming compound. Therefore, there is no risk as to excessive removal of the material of the electrically conductive surface due to the treatment as with previous methods while providing smooth surfaces. Such removal would particularly be important if the electrically conductive surface is a copper layer being very thin such as in semi-additive processing. Base substrates used in printed circuit board manufacturing for high-sophisticated applications comprise an electroless copper base layer which is only about 1 µm thick and onto which a photo-imageable resist is laminated and processed to form a circuitry. As copper pretreatment according to the present invention does virtually not remove any copper from such thin copper base layers, there is, even in portions of the surface area, no risk of complete copper removal. Copper removal using the compounds according to the invention has emerged to be at most 0.1 to 0.2 µm of copper.

Accordingly, the release layer forming compound acts as a non-etching adhesion promoter. Good adherence despite low roughness is assumed to be due to certain specific structural features present in the non-etching adhesion agent molecules which mediate adherence between the electrically conductive surface and the polymeric deposit. In the heterocyclic compounds comprising at least one thiol moiety, the thiol moiety is believed to be effective in strongly bonding to said surface while the heterocyclic ring system is believed to be effective in strongly bonding to the polymeric deposit.

The release layer forming compound is believed to form a release layer located between the electrically conductive surface and the plated conductive circuitry. The heterocyclic compounds can be detected to be located both on the electrically conductive surface of the auxiliary substrate and on the surface of the circuitry after both have been separated from each other mechanically. It is for this reason that the auxiliary substrate may be easily mechanically removed from the dielectric material and embedded electrically conductive pattern. Therefore, it is not required to overcome strong forces to peel off the auxiliary substrate from the circuit carrier layer, consequently avoiding that warping or other impairing of the dimensional integrity of the circuit carrier layer occurs. This furthermore avoids using chemical etching solutions, such as in the methods disclosed in EP 0 545 328 B1, US 4,606,787 and US 2006/0016553 A1. Therefore, the method of the invention is cost-saving, waste water saving and finally copper saving. Mechanically peeling the auxiliary substrate from the plated conductive circuitry also offers the opportunity to reuse the auxiliary substrate several times for producing circuit carrier layers.

The above release layer forming compounds have turned out to be effective in preparing the electrically conductive surface of the auxiliary substrate, especially a copper surface, for achieving good adherence of a polymeric deposit, more specifically the resist coating, being applied thereon.

### Detailed Description of the Invention

For the purpose of the present invention the term "alkyl" is defined herein as a group of saturated compounds having in the skeleton thereof but carbon atoms, these compounds comprising all conceivable isomers thereof. For example, C₁-C₆ alkyl means methyl, ethyl, propyl, isopropyl, butyl, isobutyl, tert-butyl, pentyl, isopentyl, tert-pentyl, neo-pentyl, hexyl, 2-methyl pentyl, 3-methyl pentyl, 2,3-diethyl butyl and C₁-C₄ alkyl means methyl, ethyl, propyl, isopropyl, butyl, isobutyl, tert-butyl. These compounds may also be substituted wherein the substituents may comprise groups having a skeleton which may comprise carbon as well as other atoms.

For the purpose of the present invention the term "oxirane" is defined herein as a three-membered cyclic radical having an oxygen atom and two carbon atoms in the ring, the simplest specimen being an epoxide ring which is an unsubstituted oxirane.

For the purpose of the present invention the term "thiol" or "mercaptan" means a -SH moiety or a salt thereof.

For the purpose of the present invention the term "circuit carrier" is defined herein as a device which is used to provide electrical interconnections between various electronic components and other components mounted thereon, such as resistors, capacitors, transistors, integrated circuits, transformers, LEDs, switches, edge connectors and the like. A circuit carrier may be a printed circuit board or a hybrid circuit board or a multi chip module or the like.

For the purpose of the present invention the term "circuit carrier layer" is defined herein as a device which forms, together with other circuit carrier layers, a circuit carrier. The circuit carrier layers will be stacked one over the other and bonded together to form the circuit carrier. Each circuit carrier layer comprises a dielectric substrate and conductor structures embedded in the surface thereof. Electrical connection between the conductor structures of two circuit carrier layers being located adjacent in a circuit carrier is realized by through vias between the conductor structures of the two circuit carrier layers, wherein said through vias are filled with electrically conductive material, preferably with copper.

For the purpose of the present invention the term "non-resist" in the term "non-etching non-resist composition" is defined herein to indicate that the composition is not a film forming composition which means that it does not contain a binder for example, like a polymer binder, for forming a film on the surface of the treated copper or copper alloy surface. Therefore, the adhesion promoter is not mixed into a polymer forming a polymer layer on the surface to be treated, such as a resist layer which is used to prevent part of the surface being soldered for example or to prevent etching of exposed copper for example or to prevent metal deposition on exposed copper for example.

The release layer forming compounds preferably comprise a heterocyclic moiety which contains at least two nitrogen atoms.

Even more preferably, at least one of said heterocyclic compounds having at least one thiol group comprises a heterocyclic moiety having a single ring moiety comprising at least two nitrogen atoms.

Even more preferably, at least one of said heterocyclic compounds having at least one thiol group is a triazole compound being substituted with at least one thiol moiety.

Even more preferably, at least one of said heterocyclic compounds having at least one thiol group is selected from the group comprising compounds having formulae IA and IB: 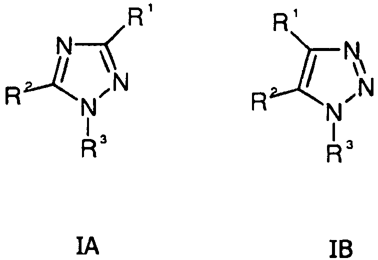 wherein R¹ and R² are independently selected from the group comprising H, SR⁴, OR⁴, NR⁵R⁶ and C₁-C₄ alkyl; wherein R³ is H or C₁-C₃ alkyl; wherein R⁴ is selected from the group comprising H, Li, Na, K and NH₄; wherein R⁵ and R⁶ are independently selected from the group comprising H, CH₃ and C₂H₅; with the proviso that at least one of R¹ and R² is SR³ with R³ being H, Li, Na, K and NH₄.

Most preferably, at least one of said heterocyclic compounds having at least one thiol group is selected from the group comprising 1 H-1,2,4-triazole-3-thiol (1,2,4-triazole-3-thiol, 3-mercaptotriazole, CAS No. 3179-31-5), 3-amino-1,2,4-triazole-5-thiol (3-amino-5-mercapto-1,2,4-triazole, CAS No. 16691-43-3), 2-mercaptobenzothiazole and 2-mercaptobenzimidazole. 1H-1,2,4-triazole-3-thiol and 3-amino-1,2,4-triazole-5-thiol are the most preferred release layer forming compounds.

The release layer forming compound is preferably included in a release layer forming composition, the concentration thereof in the composition preferably being at least about 1 mg/l, more preferably at least about 2 mg/l, even more preferably at least about 5 mg/l and most preferably at least about 10 mg/l and may be for example about 10 or about 15 or about 20 or about 30 mg/l. The concentration of the release layer forming compound in the release layer forming composition is at most about 1000 mg/l, more preferably at most about 500 mg/l, even more preferably at most about 200 mg/l, even more preferably at most about 100 mg/l and most preferably at most about 50 mg/l. If more than one release layer forming compound is used in the release layer forming composition, the above concentration values are meant to define the sum of all concentrations of adhesion agents contained in the composition.

In order to assure that the electrically conductive surface of the auxiliary substrate, a metal surface for example, more preferably a copper surface, is virtually unaffected by the release layer forming composition comprising the release layer forming compound, this composition is free of an oxidant for the material forming the electrically conductive surface, copper or a copper alloy for example. Therefore, this composition does not etch this material. For copper forming the electrically conductive surface, the composition is therefore free of hydrogen peroxide, any salts of peroxodisulfate, any salt of monooxopersulfate and of any other peroxide like perboric acid or performic acid, for example.

The release layer forming compound may preferably be used while being dissolved in a solvent, preferably an aqueous solvent thus forming a release layer forming composition. The release layer forming composition optionally further comprises at least one mineral acid or at least one organic acid. In general, these acids render the composition acidic, such that the pH thereof is attained to be in the range defined herein above. More preferably, the mineral acid is selected from the group comprising sulfuric acid and phosphoric acid. Most preferably it is sulfuric acid. The concentration of the sulfuric acid is preferably at least about 5 ml, more preferably at least about 50 ml, even more preferably at least about 75 ml and most preferably at least about 100 ml concentrated sulfuric acid in 1 l of the composition and is preferably at most about 300 ml, more preferably at most about 250 ml, even more preferably at most about 200 ml and most preferably at most about 150 ml concentrated sulfuric acid in 1 l of the composition. A preferred release layer forming composition contains about 30 mg/l of a release layer forming compound and about 50 ml/l concentrated sulfuric acid.

The above release layer forming compound does not interfere with the copper plating process and it also does not pose the danger of contaminating the metal plating bath used in method step d). The chosen compound acts as a release layer forming compound forming a release film between the treated electrically conductive surface of the auxiliary substrate, a copper surface for example, and copper plated on this surface to form the electrically conductive pattern and, at the same time, as a non-etching adhesion promoter between the electrically conductive surface of the auxiliary substrate, a copper surface for example, and the resist coating.

The electrically conductive surface to be treated with the heterocyclic compound comprising at least one thiol moiety is preferably first contacted with an aqueous solution of a mineral acid, to remove any soil from said surface prior to having the release layer forming compound impacting on the electrically conductive surface. This mineral acid may be sulfuric acid. An aqueous solution of sulfuric acid may have a concentration of from about 10 ml to about 150 ml, more preferably from about 20 ml to about 100 ml and is most preferably about 50 ml concentrated sulfuric acid in 1 I of this solution for example.

The auxiliary substrate may be rigid or flexible. More preferably the auxiliary substrate is a flexible substrate. If the substrate is rigid it may be a stainless steel plate. The stainless steel plate may have a copper film applied thereon. If it is flexible it may be a dielectric, for example plastic foil having an electrically conductive surface on at least one side thereof. The dielectric may for example be a polyethyleneterephthalate (PET). It may also be a copper foil.

More preferably, each electrically conductive surface of the auxiliary substrate may be a metal surface, even more preferably a copper surface. Even more preferably, the auxiliary substrate may comprise a copper foil on one side or on both sides thereof.

The resist coating may be a photoresist film, more preferably a dry film, alternatively a liquid film. The dry film is a common imageable photoresist consisting of a cover or support sheet, a photo-imageable layer, and a protective layer, as provided by DuPont or Hitachi. Liquid photo resist are applied directly onto the copper layer by, e.g., roller coating, curtain coating, without protective layers (e.g., Huntsman, Rohm & Haas, Atotech). The resist coating is preferably patterned by first depositing the resist coating to the electrically conductive surface of the auxiliary substrate, wherein this electrically conductive surface has been treated with the release layer forming compound, thereafter exposing the photoresist coating being deposited to the electrically conductive surface with actinic light and finally developing the exposed photoresist coating.

In a preferred embodiment of the present invention the patterned resist coating is, after method step d) and before method step e), removed from the electrically conductive surface. Then, only the electrically conductive pattern formed in the at least one opening of the patterned resist coating is left over on the electrically conductive surface, protruding therefrom.

Embedding the electrically conductive pattern into the dielectric material preferably comprises hot press laminating, *i.e.,* a process which comprises depositing the dielectric material by laminating same to the electrically conductive surface which comprises the electrically conductive pattern while applying heat to the dielectric material. Such method enables precise embedding the electrically conductive pattern into the dielectric material without any voids.

Finally, separating each dielectric material layer with the respective embedded electrically conductive pattern and the auxiliary substrate from each other comprises mechanically pulling-off the auxiliary substrate together with the electrically conductive surface from the circuit carrier layer formed thereon. Pulling-off may comprise about 90° peeling off.

The circuit carrier layers may be further processed in order to enhance adhesion between two such circuit carrier layers and/or an additional dielectric layer interposed between the two circuit carrier layers in order to form a circuit carrier. Such further processing may comprise copper roughening or again treatment with a non-etching adhesion promoter described above for example.

The circuit carrier layers are bonded together by laminating same together while applying heat to the stack of these layers. The circuit carrier layers may be bonded together using conventional methods. One preferred method is the BondFilm® (Atotech Deutschland GmbH, DE) method. This method comprises treating the copper surfaces of the circuit carrier layers with a solution containing hydrogen peroxide, at least one acid, sulfuric acid for example, at least one nitrogen-containing, five-membered, heterocyclic compound which contains no sulfur, selenium or tellurium atom in the heterocycle, such as a triazole, a tetrazole, an imidazole, a pyrazole or a purine, and at least one bonding compound, such as a sulfinic acid, a selenic acid, a telluric acid, a heterocyclic compound which contains at least one sulfur, selenium and/or tellurium atom in the heterocycle, as well as a sulfonium, selenonium and telluronium salt, and bonding the circuit carrier layers comprising the so-treated copper surfaces and a prepreg located between these layers together by applying heat and pressure. This method is described in detail in EP 1 051 888 B1, the disclosure of which is incorporated herein by reference.

In another method ('Secure HFz' of Atotech Deutschland GmbH, DE), a tin layer is formed on the copper surfaces of the circuit carrier layers, the tin layer is converted to tin oxide or tin hydroxide and thereafter a silane bonding mixture is applied to the surface of the tin oxide or hydroxide while forming an adherent organosilane coating thereon, wherein the silane bonding mixture comprises a ureido silane and a disilyl crosslinking agent. The circuit carrier layers comprising the so-treated copper surfaces and a prepreg located between these layers are finally bonded together by applying heat and pressure. This method is described in detail in EP 0 431 501 A2, the disclosure of which is incorporated herein by reference.

Once two circuit carrier layers have been bonded together to form an integral two-layer device, through vias may be formed in order to electrically connect the electrically conductive pattern of one of the two layers with the electrically conductive pattern of the other one. Such via forming may preferably be performed with laser drilling.

A couple of such two-layer devices (or alternatively of individual carrier layers) may be further bonded together to form a circuit carrier having a plurality of layers. Additional electrically conductive patterns may be formed on the outer sides of this circuit carrier as well as through holes partially or wholly penetrating the stack.

The method steps performed for treating the electrically conductive surface with the release layer forming compound in method step b), for forming the resist coating in method step c) and for electrodepositing a metal in method step d) as described herein may be performed in a conventional dip-tank technique (vertical processing) or in a conveyorized machine (horizontal processing).

To illustrate the present invention, an example is given in the following. This example does not limit the scope of the invention, but rather is a specific embodiment of the invention:

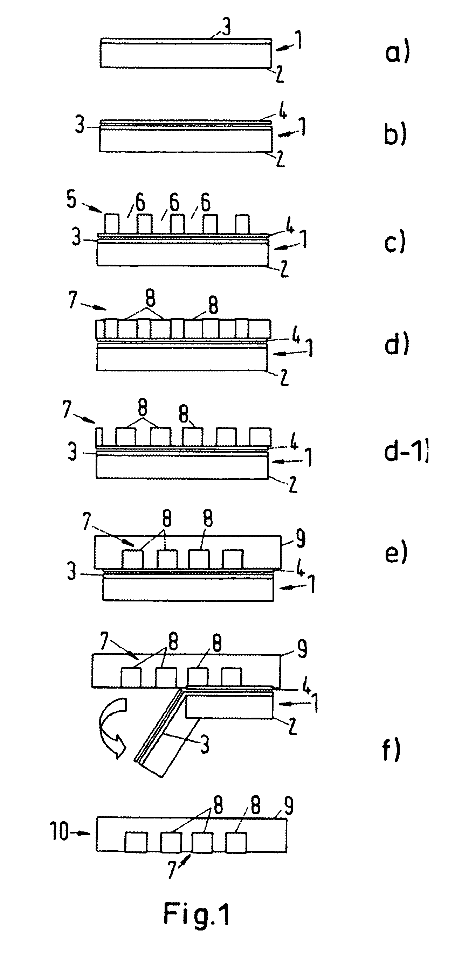

Fig. 1 schematically shows a process sequence according to the present invention to produce a circuit carrier layer:
Fig. 2 shows an optical micrograph (transmitted light) (left) and graphical reproduction of the micrograph (right) of a dielectric material after a method using the method steps of the invention was performed, with the proviso that 5-carboxybenzotriazole was used instead of the release layer forming compound. (Comparative Example)
Fig. 3 shows an optical micrograph (transmitted light) of a dielectric material after the method of the invention was performed. 1 H-1,2,4-triazole-3-thiol was used as the release layer forming compound (Example of the Invention).

In method step a) an auxiliary substrate 1 having two sides is provided. This substrate comprises a base sheet 2, a dielectric foil for example, and a copper foil 3 on one side thereof. The dielectric foil may be a PET foil.

Then, in method step b), the auxiliary substrate 1 is treated with a release layer forming compound. This treatment is believed to form a release layer 4. The existence of such layer will only be postulated here in order to show a change in characteristics of the surface of the copper foil 3. Such change in characteristics will bring about the following effects: The release layer forming compound will act as a release means to promote release of the subsequently copper conductor pattern formed on the copper foil from said copper foil and it will also have the subsequently deposited resist coating firmly adhering to the copper foil.

The release layer forming compound is a heterocyclic compound having at least one thiol group. A most preferred compound will be 1 H-1,2,4-triazole-3-thiol or 3-amino-1,2,4-triazole-5-thiol which is dissolved in water or optionally in an aqueous acidic solution. For this to be performed, the auxiliary substrate 1 is first cleaned using an aqueous dilute solution of sulfuric acid and is thereafter treated with the solution containing the release layer forming compound.

After rinsing and drying the auxiliary substrate 1 being treated with the release layer forming compound, the auxiliary substrate is further treated by forming, in method step c), a patterned resist coating 5 on the surface of the copper foil 3 of the auxiliary substrate which has been treated with the release layer forming compound. The patterned resist coating has at least one resist opening 6 thereby exposing the copper surface. The patterned resist coating is formed by first depositing a photoresist layer onto the copper foil, then exposing said resist layer to actinic radiation which images the conductive pattern, either in a positive or negative image, depending on the type of the photoresist being employed and finally developing the exposed photoresist layer in a developing solution. Such processes are well-known in the art. The resist may be a dry film resist or a liquid resist. In the latter case the resist may be an electrophoretic resist, *i.e.*, this liquid resist is deposited to the copper surface using a solution with electrophoretic particles dispersed therein while applying an electric voltage between the copper foil and a counter electrode. The resist coating is preferably a dry film resist which may be any conventional photoresist being suitable to produce ultra-fine line geometries.

Thereafter in method step d), a copper pattern 7 is formed which comprises a plurality of copper conductor structures 8. The copper pattern is formed in the resist openings 6 by electrodepositing a metal on the exposed surface of the copper foil 3. For this to be achieved, the auxiliary substrate 1 coated with the resist is first cleaned by treating same in an aqueous dilute sulfuric acid solution. Thereafter, pattern plating is applied to the substrate, using an acid copper plating electrolyte which is suitable to deposit an ultra-fine line copper deposit in the resist openings.

After the auxiliary substrate 1 which has been provided with the patterned resist coating 5 and with the copper conductor pattern 7 has been rinsed and dried, the resist coating 5 is removed in method step d-1) by stripping same from the surface of the copper foil 3. Such removal is performed using conventional stripping compositions, such as an alkaline aqueous solution.

Then in method step e), after the auxiliary substrate 1 which is provided with the copper pattern 7 has been rinsed and dried, a dielectric material 9 is deposited to that side of the auxiliary substrate 1 where the copper conductor pattern 7 is located, by hot-press lamination such that the copper pattern is completely embedded into the dielectric material without any voids created therein. The dielectric material may be an epoxy resin, if possible filled with a reinforcing material such as glass fibers.

Then according to method step f), after having completed method step e), the device so formed is further processed: The auxiliary substrate 1 comprising the base sheet 2 and the copper foil 3 on one side thereof as well as any release layer 4 formed on the copper foil is removed by mechanically peeling same off from the circuit carrier layer formed on this auxiliary substrate resulting in the circuit carrier layer 10.

The auxiliary substrate 1 may be reused to produce another circuit carrier layer 10 in accordance with the above method sequence.

### Examples

The invention will now be illustrated by reference to the following non-limiting Examples. For all experiments polyimide sheets having a 17 µm thick copper layer 3 on one side were used as the auxiliary substrate 1.

The dry film photoresist (Hitachi RY 3325SG) was processed with standard techniques. The copper conductor pattern 7 was electroplated with an average layer thickness of 18 µm with 1.5 A/dm² from an acidic copper electrolyte (Cupracid® TLC, a product of Atotech Deutschland GmbH). The circuit layout used throughout all experiments comprises trenches of various dimensions including trenches having a width of 30 µm. Isola 104 ML sheets were used as the dielectric material 9. Laminating was done according to the technical description provided by Isola: T = 180 °C, t = 70 min, p = 15 bar in a hydraulic press with vacuum support. Finally the auxiliary substrate 1 was peeled off from the dielectric material 9 bearing the copper conductor pattern 7. The dielectric material 9 was then inspected with an optical microscope with transmitted light in order to monitor the copper conductor pattern 7.

### Example 1 (Comparative Example):

The auxiliary substrate 1 was immersed for 60 s at 35°C in a composition consisting of 50 ml/l of 96 wt.-% sulfuric acid, 30 mg/l 5-carboxybenzotriazole and water and dried prior to application of the dry film photoresist. The coating of 5-carboxybenzotriazole served as the release layer 4.

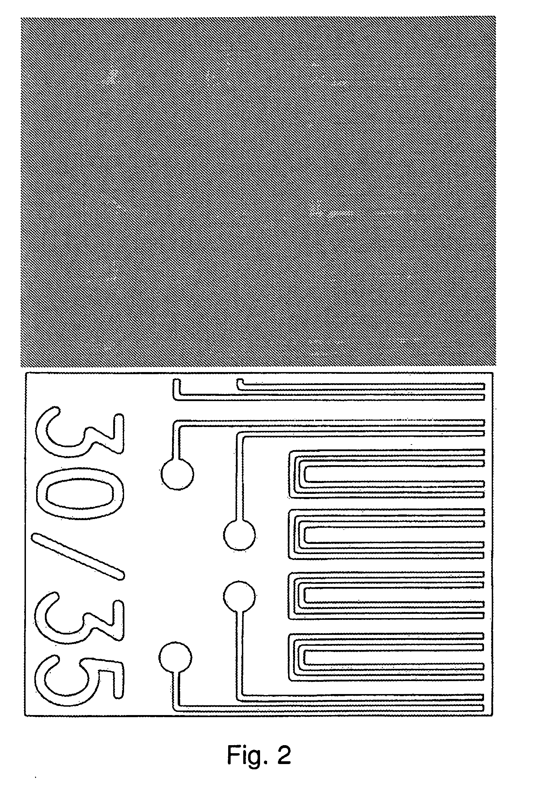

An optical micrograph of the structured side (side which should have the embedded circuit structure) is shown in Fig. 2. The trenches were not filled with the copper conductor pattern 7, *i.e*., 5-carboxybenzitriazole did not serve as a release layer 4 forming compound. The copper conductor pattern firmly sticked to the copper layer 3 of the auxiliary substrate 1 when same was peeled off from the dielectric and therefore was transferred to the auxiliary substrate. Consequently, the light structures shown in the photograph of Fig. 2 indicate that no copper was contained in the dielectric.

### Example 2 (Example of the Invention):

The auxiliary substrate 1 was immersed for 60 s at 35°C in a composition consisting of 30 mg/l 1 H-1,2,4-triazole-3-thiol and water prior to application of the dry film photoresist.

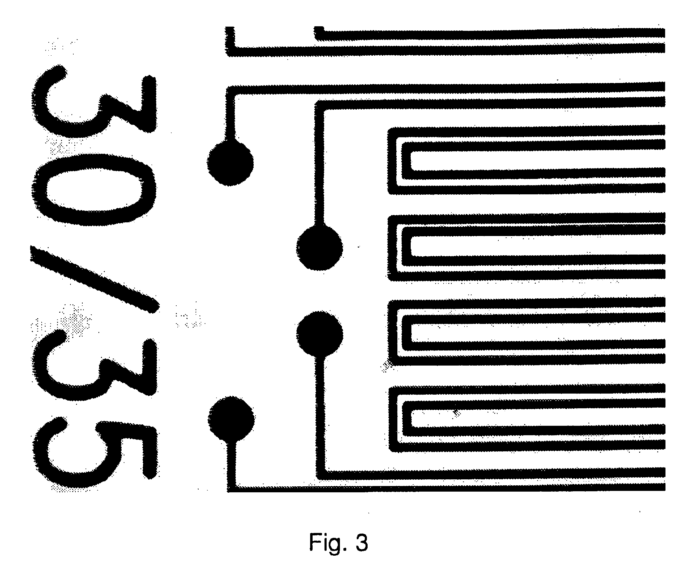

An optical micrograph of the structured side is shown in Fig. 3. The trenches were filled with the copper conductor pattern 7, *i.e.,* an aqueous solution of 1 H-1,2,4-triazole-3-thiol served as a release layer 4 forming compound. The dark structures shown in this photograph indicate that copper formed the structures and that the copper did not stick to the copper foil of the auxiliary substrate, but stayed in the dielectric when the auxiliary substrate containing the circuitry was peeled off from the dielectric.

### Example 3 (Example of the Invention):

The auxiliary substrate 1 was immersed for 60 s at 35°C in a composition consisting of 30 mg/l 1H-1,2,4-triazole-3-thiol, 50 ml/l sulfuric acid (96 wt.-%) and water prior to application of the dry film photoresist.

The trenches were completely filled with the copper conductor pattern 7 after peeling the circuitry 8 off from the auxiliary substrate 1.

### Example 4 (Comparative Example):

While repeating Example 1, 3 amino-1H-1,2,4-triazole was used instead of 5-carboxybenzotriazole. It was found however, that the dry film photoresist did not exhibit sufficient adhesion to the copper foil of the auxiliary substrate 1. Furthermore, as with carboxybenzotriazole, the copper conductor pattern firmly sticked to the copper layer 3 of the auxiliary substrate 1 when same was peeled off from the dielectric. Therefore, the trenches were not filled with the copper conductor pattern 7, *i.e.*, 3-amino-1H-1,2,4-triazole did not serve as a release layer 4 forming compound.

### Example 5 (Comparative Example):

While repeating Example 1, 1,2,3-benzotriazole was used instead of 5-carboxybenzotriazole. It was found however, that as with carboxybenzotriazole, the copper conductor pattern firmly sticked to the copper layer 3 of the auxiliary substrate 1 when same was peeled off from the dielectric. Therefore, the trenches were not filled with the copper conductor pattern 7, *i.e.*, 1,2,3-benzotriazole did not serve as a release layer 4 forming compound.

### Example 6 (Comparative Example):

While repeating Example 1, 2-mercaptobenzothiazole was used instead of 5-carboxybenzotriazole. It was found however, that the dry film photoresist did not exhibit sufficient adhesion to the copper foil of the auxiliary substrate 1. Furthermore, as with carboxybenzotriazole, the copper conductor pattern firmly sticked to the copper layer 3 of the auxiliary substrate 1 when same was peeled off from the dielectric. Therefore, the trenches were not filled with the copper conductor pattern 7, *i.e.*, 2-mercaptobenzothiazole did not serve as a release layer 4 forming compound.

## Claims

1. A method of manufacturing a circuit carrier layer (10), the method comprising the following method steps:
a) Providing an auxiliary substrate (1) having two sides, at least one of said sides having an electrically conductive surface (3);
b) Treating at least one of the at least one electrically conductive surface (3) with at least one release layer (4) forming compound;
c) Forming a patterned resist coating (5) on at least one of said at least one electrically conductive surface (3) which has been treated with said at least one release layer (4) forming compound, the patterned resist coating (5) having at least one resist opening (6) thereby exposing the electrically conductive surface (3);
d) Forming an electrically conductive pattern (7) in the at least one resist opening (6) by electrodepositing a metal (8) on the exposed electrically conductive surface (3);
e) Embedding each electrically conductive pattern (7) into a dielectric material (9) by forming a respective dielectric material layer on the respective side of the auxiliary substrate (1); and
f) Separating each dielectric material layer comprising the respective embedded electrically conductive pattern (7) and the auxiliary substrate (1) from each other,
**characterized in that** the release layer (4) forming compound is selected from the group comprising triazole compounds each having at least one -SH group or salt group thereof.

2. The method of manufacturing a circuit carrier layer according to claim 1, wherein the auxiliary substrate is a flexible substrate.

3. The method of manufacturing a circuit carrier layer according to any one of the preceding claims, wherein the auxiliary substrate is a flexible substrate having a copper foil on one side thereof.

4. The method of manufacturing a circuit carrier layer according to any one of the preceding claims, wherein the patterned resist coating is formed by depositing a photoresist coating, exposing the photoresist coating and developing the photoresist coating.

5. The method of manufacturing a circuit carrier layer according to any one of the preceding claims, wherein the patterned resist coating is removed between method steps d) and e).

6. The method of manufacturing a circuit carrier layer according to any one of the preceding claims, wherein the step of separating each dielectric material layer with the respective embedded electrically conductive pattern and the carrier substrate from each other comprises mechanically peeling the auxiliary substrate off from the dielectric material layer with the respective embedded electrically conductive pattern.

7. The method of manufacturing a circuit carrier layer according to any one of the preceding claims, wherein at least one of the triazole compounds each having at least one -SH group or salt group thereof is selected from the group comprising compounds having formulae IA and IB: 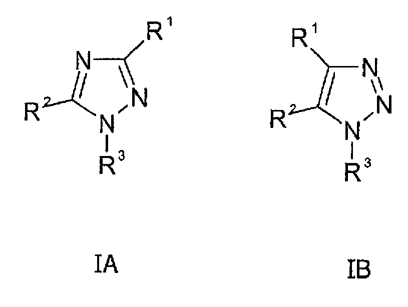 wherein R¹ and R² are independently selected from the group comprising H, SR⁴, OR⁴, NR⁵R⁶, and C₁-C₄ alkyl; R³ is H or C₁-C₃ alkyl; R⁴ is selected from the group comprising H, Li, Na, K and NH₄; R⁵ and R⁶ are independently selected from the group comprising H, CH₃, and C₂H₅; with the proviso that at least one of R¹ and R² is SR⁴ with R⁴ being H, Li, Na, K, and NH₄.

8. The method of manufacturing a circuit carrier layer according. to any one of the preceding claims, wherein at least one of the triazole compounds each having at least one -SH group or salt group thereof is selected from the group comprising 1H-1,2,4-triazole-3-thiol and 3-amino-1,2,4-triazole-5-thiol.

9. A use of the method of manufacturing a circuit carrier layer according to any one of the preceding claims for manufacturing a circuit carrier by further joining together at least two circuit carrier layers.

## Patentansprüche

1. Verfahren zur Herstellung einer Schaltungsträgerlage (10), wobei das Verfahren die folgenden Verfahrensschritte umfasst:
(a) Bereitstellen eines Hilfssubstrats (1), das zwei Seiten aufweist, wobei mindestens eine der Seiten eine elektrisch leitende Oberfläche (3) aufweist;
(b) Behandeln mindestens einer der mindestens einen elektrisch leitenden Oberfläche (3) mit mindestens einer Verbindung zur Bildung einer Trennschicht (4);
(c) Bilden einer strukturierten Resistbeschichtung (5) auf mindestens einer der mindestens einen elektrisch leitenden Oberfläche (3), die mit der mindestens einen Verbindung zur Bildung der Trennschicht (4) behandelt worden ist, wobei die strukturierte Resistbeschichtung (5) mindestens eine Resistöffnung (6) aufweist, wobei die elektrisch leitende Oberfläche (3) freiliegt;
(d) Bilden einer elektrisch leitenden Struktur (7) in der mindestens einen Resistöffnung (6) durch Elektroabscheiden eines Metalls (8) auf der freiliegenden elektrisch leitenden Oberfläche (3);
(e) Einbetten jeder elektrisch leitenden Struktur (7) in ein dielektrisches Material (9) durch Bilden einer entsprechenden dielektrischen Materialschicht auf der entsprechenden Seite des Hilfssubstrats (1); und
(f) Trennen jeder dielektrischen Materialschicht, die die entsprechende eingebettete elektrisch leitende Struktur (7) aufweist, von dem Hilfssubstrat (1),
**dadurch gekennzeichnet, dass** die Verbindung zur Bildung der Trennschicht (4) ausgewählt ist aus der Gruppe, umfassend Triazol-Verbindungen, die jeweils mindestens eine -SH-Gruppe oder deren Salzgruppe aufweisen.

2. Verfahren zur Herstellung einer Schaltungsträgerlage nach Anspruch 1, wobei das Hilfssubstrat ein flexibles Substrat ist.

3. Verfahren zur Herstellung einer Schaltungsträgerlage nach einem der vorstehenden Ansprüche, wobei das Hilfssubstrat ein flexibles Substrat ist, das an deren einer Seite eine Kupferfolie aufweist.

4. Verfahren zur Herstellung einer Schaltungsträgerlage nach einem der vorstehenden Ansprüche, wobei die strukturierte Resistbeschichtung durch Abscheiden einer Photoresistbeschichtung, durch Belichten der Photoresistbeschichtung und Entwickeln der Photoresistbeschichtung gebildet wird.

5. Verfahren zur Herstellung einer Schaltungsträgerlage nach einem der vorstehenden Ansprüche, wobei die strukturierte Resistbeschichtung zwischen den Verfahrensschritten d) und e) entfernt wird.

6. Verfahren zur Herstellung einer Schaltungsträgerlage nach einem der vorstehenden Ansprüche, wobei der Schritt des Trennens jeder dielektrischen Materialschicht, die die entsprechende eingebettete elektrisch leitende Struktur aufweist, von dem Trägersubstrat das mechanische Abschälen des Hilfssubstrats von der dielektrischen Materialschicht, die die entsprechende eingebettete elektrisch leitende Struktur aufweist, umfasst.

7. Verfahren zur Herstellung einer Schaltungsträgerlage nach einem der vorstehenden Ansprüche, wobei mindestens eine der Triazol-Verbindungen, die jeweils mindestens eine -SH-Gruppe oder deren Salzgruppe aufweisen, ausgewählt ist aus der Gruppe, umfassend Verbindungen mit den Formeln IA und IB: 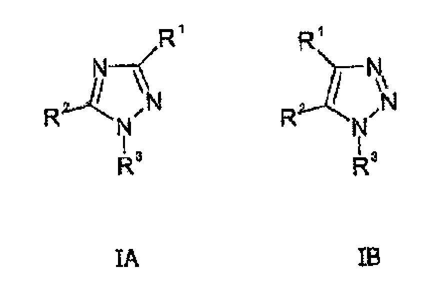 wobei R¹ und R² unabhängig voneinander ausgewählt sind aus der Gruppe, umfassend H, SR⁴, OR⁴, NR⁵R⁶, und C₁- bis C₄-Alkyl, R³ ausgewählt ist aus H oder C₁- bis C₃-Alkyl, R⁴ ausgewählt ist aus der Gruppe, umfassend H, Li, Na, K und NH₄, R⁵ und R⁶ unabhängig voneinander ausgewählt sind aus der Gruppe, umfassend H, CH₃ und C₂H₅, mit der Maßgabe, dass mindestens eines von R¹ und R² SR⁴ ist, wobei R⁴ H, Li, Na, K und NH₄ ist.

8. Verfahren zur Herstellung einer Schaltungsträgerlage nach einem der vorstehenden Ansprüche, wobei mindestens eine der Triazol-Verbindungen, die jeweils mindestens eine -SH-Gruppe oder deren Salzgruppe aufweist, ausgewählt ist aus der Gruppe, umfassend 1H-1,2,4-Triazol-3-thiol und 3-Amino-1,2,4-triazol-5-thiol.

9. Anwendung des Verfahrens zur Herstellung einer Schaltungsträgerlage nach einem der vorstehenden Ansprüche zur Herstellung eines Schaltungsträgers durch weiteres Verbinden von mindestens zwei Schaltungsträgerlagen miteinander.

## Revendications

1. Procédé de fabrication d'une couche porte-circuit de circuit (10), le procédé comprenant les étapes de procédé suivantes :
a) la fourniture d'un substrat auxiliaire (1) ayant deux côtés, au moins un desdits côtés ayant une surface électroconductrice (3) ;
b) le traitement d'au moins une de l'au moins une surface électroconductrice (3) avec au moins un composé de formation de couche de libération (4) ;
c) la formation d'un revêtement de réserve à motif (5) sur au moins une de ladite au moins une surface électroconductrice (3) qui a été traitée avec ledit au moins un composé de formation de couche de libération (4), le revêtement de réserve à motif (5) ayant au moins une ouverture de réserve (6) exposant ainsi la surface électroconductrice (3) ;
d) la formation d'un motif électroconducteur (7) dans l'au moins une ouverture de réserve (6) par dépôt électrolytique d'un métal (8) sur la surface électroconductrice (3) exposée ;
e) l'intégration de chaque motif électroconducteur (7) dans un matériau diélectrique (9) en formant une couche de matériau diélectrique respective sur le côté respectif du substrat auxiliaire (1) ; et
f) la séparation de chaque couche de matériau diélectrique comprenant le motif électroconducteur (7) incorporé respectif et le substrat auxiliaire (1) l'une de l'autre,
**caractérisé en ce que** le composé de formation de couche de libération (4) est choisi dans le groupe comprenant les composés triazole ayant chacun au moins un groupe -SH ou un groupe sel de celui-ci.

2. Procédé de fabrication d'une couche porte-circuit de circuit selon la revendication 1, dans lequel le substrat auxiliaire est un substrat flexible.

3. Procédé de fabrication d'une couche porte-circuit de circuit selon l'une quelconque des revendications précédentes, dans lequel le substrat auxiliaire est un substrat flexible ayant une feuille de cuivre sur un de ses côtés.

4. Procédé de fabrication d'une couche porte-circuit de circuit selon l'une quelconque des revendications précédentes, dans lequel le revêtement de réserve à motif est formé en déposant un revêtement de résine photosensible, en exposant le revêtement de résine photosensible et en développant le revêtement de résine photosensible.

5. Procédé de fabrication d'une couche porte-circuit de circuit selon l'une quelconque des revendications précédentes, dans lequel le revêtement de réserve à motif est éliminé entre les étapes de procédé d) et e).

6. Procédé de fabrication d'une couche porte-circuit de circuit selon l'une quelconque des revendications précédentes, dans lequel l'étape de séparation de chaque couche de matériau diélectrique avec le motif électroconducteur incorporé respectif et le substrat porteur l'une de l'autre comprend le pelage mécanique du substrat auxiliaire hors de la couche de matériau diélectrique avec le motif électroconducteur incorporé respectif.

7. Procédé de fabrication d'une couche porte-circuit de circuit selon l'une quelconque des revendications précédentes, dans lequel au moins un des composés triazole ayant chacun au moins un groupe -SH ou un groupe sel de celui-ci est choisi dans le groupe comprenant des composés de formules IA et IB : 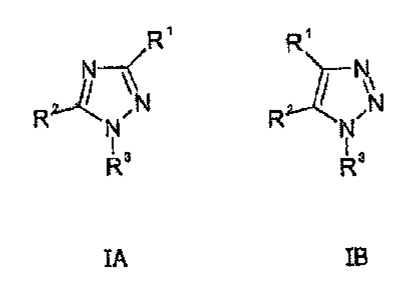 dans lesquelles R¹ et R² sont indépendamment choisis dans le groupe comprenant H, SR⁴, OR⁴, NR⁵R⁶ et alkyle en C₁ à C₄ ; R³ est H ou alkyle en C₁ à C₃ ; R⁴ est choisi dans le groupe comprenant H, Li, Na, K et NH₄ ; R⁵ et R⁶ sont indépendamment choisis dans le groupe comprenant H, CH₃ et C₂H₅ ; à condition qu'au moins un de R¹ et R² soit SR⁴, R⁴ étant H, Li, Na, K et NH₄.

8. Procédé de fabrication d'une couche porte-circuit de circuit selon l'une quelconque des revendications précédentes, dans lequel au moins un des composés triazole ayant chacun au moins un groupe -SH ou un groupe sel de celui-ci est choisi dans le groupe comprenant le 1H-1,2,4-triazol-3-thiol et le 3-amino-1,2,4-triazole-5-thiol.

9. Utilisation du procédé de fabrication d'une couche porte-circuit de circuit selon l'une quelconque des revendications précédentes pour fabriquer un porte-circuit en assemblant en outre au moins deux couches porte-circuit.
